(19) Europäisches Patentamt
European Patent Office
Office européen des brevets

(11) EP 2 190 034 A1

(12) EUROPEAN PATENT APPLICATION
published in accordance with Art. 153(4) EPC

(43) Date of publication:
26.05.2010 Bulletin 2010/21

(21) Application number: 08865042.9

(22) Date of filing: 19.12.2008

(51) Int Cl.:
*H01L 31/20* (2006.01) *H01L 31/075* (2006.01)

(86) International application number:
PCT/JP2008/073176

(87) International publication number:
WO 2009/081855 (02.07.2009 Gazette 2009/27)

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(30) Priority: 21.12.2007 JP 2007329956

(71) Applicant: Mitsubishi Heavy Industries, Ltd.
Tokyo 108-8215 (JP)

(72) Inventor: NAKANO, Youji
Nagasaki-shi
Nagasaki 851-0392 (JP)

(74) Representative: Henkel, Feiler & Hänzel
Patentanwälte
Maximiliansplatz 21
80333 München (DE)

# (54) METHOD FOR MANUFACTURING PHOTOELECTRIC CONVERSION DEVICE, AND PHOTOELECTRIC CONVERSION DEVICE

(57) A process for producing a photovoltaic device having a high conversion efficiency with improved productivity. The process for producing a photovoltaic device includes an n-layer formation step of depositing an n-layer composed of crystalline silicon on a substrate disposed inside a deposition chamber under reduced pressure conditions by heating the substrate with a heating device to convert the substrate to a heated state, supplying a raw material gas to the inside of the deposition chamber, and then supplying power to a discharge electrode positioned opposing the substrate, wherein the n-layer formation step comprises depositing the n-layer with the pressure inside the deposition chamber set to not less than 500 Pa and not more than 1,000 Pa, and the distance between the substrate and the discharge electrode set to not less than 6 mm and not more than 12 mm.

FIG. 1

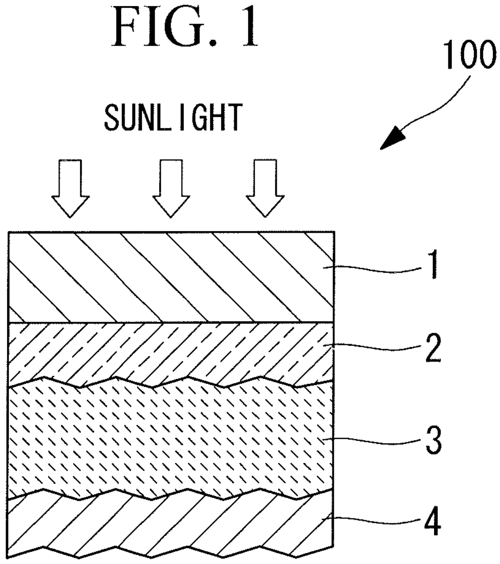


EP 2 190 034 A1

## Description

### Technical Field

The present invention relates to a process for producing a photovoltaic device, and relates particularly to a process for producing a solar cell that uses silicon as the electric power generation layer.

### Background Art

The use of solar cells as photovoltaic devices that receive light and convert the energy into electrical power is already known. Amongst solar cells, thin-film type solar cells in which thin films of silicon-based layers are stacked together to form an electric power generation layer (photovoltaic layer) offer various advantages compared with crystalline solar cells, including the fact that the silicon material costs can be reduced, the fact that deposition can be performed on large surface area substrates, meaning products having large surface areas can be obtained, and the fact that a high output can be achieved even within high-temperature environments such as summer conditions, and as a result, these thin-film type solar cells are attracting considerable attention.

One known example of the thin-film type solar cell mentioned above is a thin-film type solar cell in which an amorphous silicon-based (non-crystalline silicon-based) layer is used for the photovoltaic layer. This photovoltaic layer is formed, for example, by sequentially stacking a p-layer, an i-layer and an n-layer, each of which is composed of a thin film of amorphous silicon, on top of a substrate. Further, in recent years, much investigation has been conducted into forming the n-layer within an amorphous silicon-based photovoltaic layer as a microcrystalline silicon layer. Because forming the n-layer as a microcrystalline silicon layer increases the crystallization ratio (Raman ratio) of the n-layer, the short-circuit current decreases and the transmittance increases, resulting in reduced light loss. Furthermore, the electrical properties at the interface between the n-layer and the i-layer are also improved. This enables an improvement in the cell performance.

In recent years, as demands for reductions in the manufacturing costs of thin-film type solar cells have grown, increasing the deposition rate of the photovoltaic layer has become an important issue in terms of increasing productivity. In particular, a variety of investigations have been conducted into rapid deposition of the comparatively thick i-layer. For example, Patent Citation 1 discloses a process for depositing an i-layer composed of microcrystalline silicon under conditions including a substrate-electrode distance of not more than 8 mm and a deposition pressure of 600 to 2,000 Pa, thereby achieving a deposition rate of 2 nm/sec.

In the case of an i-layer composed of amorphous silicon, processes for increasing the productivity by either depositing the i-layer across a plurality of deposition chambers, or lengthening the deposition line for the i-layer, are also under investigation.

Patent Citation 1: Japanese Unexamined Patent Application, Publication No. 2006-216921

### Disclosure of Invention

As mentioned above, numerous investigations have been conducted into rapid deposition of the i-layer, but in the case of the p-layer and the n-layer, because the thickness is considerably less than that of the i-layer, almost no investigations have been conducted into rapid deposition.

Further, because the p-layer and the n-layer are doped with an impurity element, achieving rapid deposition has been thought impossible. The reason for this thinking is that when silicon is doped with an element such as boron (B) or phosphorus (P), the silicon crystallinity deteriorates, and therefore in order to obtain a p-layer and n-layer with a high degree of crystallinity, a high hydrogen dilution ratio equivalent to a 50- to 100-fold hydrogen dilution has been required. However, because this results in a decrease in the concentration of the silane ($SiH_4$) gas that acts as the raw material for the silicon film, the deposition rate decreases, and the film thickness distribution within the resulting p-layer and n-layer tends to worsen. Furthermore, in those cases where the n-layer is deposited on top of the i-layer, if the n-layer is deposited rapidly, then the doping element tends to diffuse into the i-layer, causing a deterioration in the interface properties and a reduction in the conversion efficiency of the solar cell. As a result, the p-layer and n-layer have generally been deposited under low pressure and at a low deposition rate.

Accordingly, even if a plurality of i-layer deposition chambers is provided to increase the productivity, because the deposition rates for the p-layer and the n-layer are very low values of not more than 0.2 nm/sec, the deposition of the p-layer and n-layer becomes rate controlling, making it impossible to achieve a significant improvement in the overall level of productivity. In order to improve the productivity of solar cells, it is necessary to shorten the takt times for the p-layer formation and the n-layer formation. For example, to achieve a takt time of 3 minutes, the deposition time is preferably not more than 100 seconds. In order to achieve deposition of a layer of the desired thickness, such as a thickness of 30 nm, within a deposition time of 100 seconds, the deposition rate must be not less than 0.30 nm/sec.

In this manner, there is a growing need for increasing the deposition rates for the p-layer and the n-layer. For example, by conducting deposition of the n-layer using the same deposition conditions as those disclosed in Patent Citation 1 for deposition of a microcrystalline silicon i-layer, the deposition rate can be increased and the film thickness distribution can be improved. However, the crystallinity of the resulting n-layer is poor, and the conversion efficiency deteriorates dramatically. Higher crystallinity can be achieved by increasing the hydrogen flow rate to increase the hydrogen dilution ratio, but this results in a decrease in the concentration of the $SiH_4$ raw material gas that produces a concomitant reduction in the deposition rate, as well as a worsening of the film thickness distribution. Further, if a combination of a favorable deposition rate and favorable crystallinity is achieved by increasing the RF power, then the doping element tends to diffuse into the underlying layer, causing a deterioration in the interface properties and a dramatic deterioration in the conversion efficiency. Accordingly, conventionally, achieving a combination of rapid deposition for the n-layer and improved cell performance has proven impossible.

The present invention has been developed in light of the issues described above, and provides a process in which by depositing an n-layer of high crystallinity at a rapid rate, a photovoltaic device having excellent conversion efficiency can be produced with improved productivity.

In order to resolve the above issues, the present invention provides a process for producing a photovoltaic device comprising an n-layer formation step of depositing an n-layer composed of crystalline silicon on a substrate disposed inside a deposition chamber under reduced pressure conditions by heating the substrate with a heating device to convert the substrate to a heated state, supplying a raw material gas to the inside of the deposition chamber, and then supplying power to a discharge electrode positioned opposing the substrate, wherein the n-layer formation step comprises depositing the n-layer with the pressure inside the deposition chamber set to not less than 500 Pa and not more than 1,000 Pa, and the distance between the substrate and the discharge electrode set to not less than 6 mm and not more than 12 mm.

The higher the deposition pressure, the more the raw material gas density within the plasma increases, and therefore even though the deposition rate is increased, a crystalline silicon n-layer having a high degree of crystallinity can still be deposited. However, if the deposition pressure exceeds 1,000 Pa, then localization of the plasma tends to occur, causing a deterioration in the film thickness distribution for the crystalline silicon n-layer. Further, hydrogen radicals are more likely to collide with the raw material gas, causing a reduction in energy and a deterioration in the n-layer crystallinity. By setting the pressure inside the deposition chamber to not less than 500 Pa and not more than 1,000 Pa, the deposition rate for the n-layer can be increased, and a crystalline silicon n-layer having a high degree of crystallinity and a favorable film thickness distribution can be deposited.

If the distance between the substrate and the discharge electrode is less than 6 mm, then the plasma region is narrowed and the quantity of plasma generated decreases, causing a decrease in the deposition rate. Moreover, the in-plane deviation in the distance between the substrate and the discharge electrode increases, causing an increase in the variation in deposition rate within the plane, and a resulting deterioration in the film thickness distribution. In contrast, if the distance between the substrate and the discharge electrode exceeds 12 mm, then the plasma is restricted to regions near the substrate and the electrode, and deposition rate tends to decrease. By setting the distance between the substrate and the discharge electrode to not less than 6 mm and not more than 12 mm, a crystalline silicon n-layer having a favorable film thickness distribution can be deposited at a rapid rate.

In the present invention, the deposition rate for the n-layer mentioned above is preferably not less than 0.3 nm/sec. By forming the n-layer at such a deposition rate, the takt time required for the n-layer deposition step can be shortened, and the productivity can be improved.

In the present invention, the n-layer is preferably deposited such that the Raman ratio for the n-layer is not less than 3.5. Provided the Raman ratio for the n-layer is not less than 3.5, a photovoltaic device having a high conversion efficiency can be obtained. The term "Raman ratio" refers to a ratio between the crystalline silicon peak intensity at 520 $cm^{-1}$ and the amorphous silicon peak intensity at 480 $cm^{-1}$ (namely, crystalline silicon peak intensity / amorphous silicon peak intensity), which is measured by Raman spectroscopy.

In the present invention, the n-layer is preferably deposited such that the film thickness distribution for the n-layer is not more than 20%. This enables deposition to be performed with a favorable film thickness distribution even during mass production of a large surface area substrate, meaning a high-quality photovoltaic device can be produced with a high yield.

Further, the above process for producing a photovoltaic device may further comprise an initial n-layer formation step immediately prior to the above n-layer formation step, wherein the initial n-layer formation step comprises depositing the initial n-layer with the pressure inside the deposition chamber set to less than 500 Pa, and the distance between the substrate and the discharge electrode set to not less than 6 mm and not more than 12 mm.

Although the deposition rate decreases under conditions of low deposition pressure, deterioration of the interface electrical properties caused by diffusion of the doping element can be suppressed. In this manner, by depositing the initial n-layer on the substrate at a pressure of less than 500 Pa, and then depositing the n-layer described above, any deterioration in the interface properties can be prevented, the conversion efficiency of the photovoltaic device can be improved, and the time required for the deposition process can be shortened, enabling an improvement in the productivity.

In this case, deposition is preferably conducted so that the thickness of the initial n-layer is preferably not less than 5 nm, and not more than 1/2 of the combined thickness of the n-layer and the initial n-layer.

If the thickness of the initial n-layer is less than 5 nm, then although the time required for deposition can be shortened, the effect of the initial n-layer in suppressing deterioration in the interface properties cannot be achieved. On the other hand, if the initial n-layer is very thick, then the deposition time becomes overly long and the productivity decreases. Provided the thickness of the initial n-layer is not less than 5 nm and not more than 1/2 of the combined thickness of the n-layer and the initial n-layer, favorable interface properties can be achieved, enabling an improvement in the conversion efficiency, and the takt time for the n-layer deposition can be shortened, enabling a further improvement in the productivity of the photovoltaic device.

The present invention also provides a thin-film photovoltaic device comprising at least a transparent conductive film, at least one photovoltaic layer and a back electrode layer disposed on top of a substrate, wherein the photovoltaic layer has at least an n-layer, and the n-layer is a crystalline silicon layer having a Raman ratio of not less than 3.5 and a film thickness distribution of not more than 20%.

A photovoltaic device of the above structure has a high degree of n-layer crystallinity and a favorable in-plane film thickness distribution, and therefore exhibits a high degree of conversion efficiency.

Furthermore, the present invention also provides a thin-film photovoltaic device comprising at least a transparent conductive film, at least one photovoltaic layer and a back electrode layer disposed on top of a substrate, wherein the photovoltaic layer has at least a stacked structure composed of an initial n-layer and an n-layer, the n-layer is a crystalline silicon layer having a Raman ratio of not less than 3.5 and a film thickness distribution of not more than 20%, and the initial n-layer is a silicon layer having a Raman ratio of less than 3.5.

A photovoltaic device of the above structure has a high degree of n-layer crystallinity, a favorable in-plane film thickness distribution and improved interface electrical properties due to the initial n-layer, and therefore exhibits an even higher degree of conversion efficiency.

The present invention enables a crystalline silicon n-layer having a high degree of crystallinity and a favorable in-plane film thickness distribution to be deposited more rapidly than has conventionally been possible. As a result, a photovoltaic device having a high degree of efficiency can be produced with improved productivity. Furthermore, by depositing an initial n-layer at low pressure to improve the interface properties, a photovoltaic device having excellent conversion efficiency can be produced.

Brief Description of Drawings

[FIG. 1] A schematic illustration of the structure of a photovoltaic device produced using a process for producing a photovoltaic device according to the present invention.

[FIG. 2] A schematic illustration describing an embodiment for producing a solar cell panel using the process for producing a photovoltaic device according to the present invention.

[FIG. 3] A schematic illustration describing an embodiment for producing a solar cell panel using the process for producing a photovoltaic device according to the present invention.

[FIG. 4] A schematic illustration describing an embodiment for producing a solar cell panel using the process for producing a photovoltaic device according to the present invention.

[FIG. 5] A schematic illustration describing an embodiment for producing a solar cell panel using the process for producing a photovoltaic device according to the present invention.

[FIG. 6] A schematic illustration of a discharge electrode used in the deposition of an n-layer of an embodiment of the present invention.

[FIG. 7] A graph illustrating the relationship between the deposition pressure and the deposition rate for the n-layer.

[FIG. 8] A graph illustrating the relationship between the deposition pressure and the film thickness distribution for the n-layer.

[FIG. 9] A graph illustrating the relationship between the deposition pressure and the Raman ratio for the n-layer.

[FIG. 10] A graph illustrating the relationship between the distance between the substrate and the discharge electrode, and the deposition rate.

[FIG. 11] A graph illustrating the relationship between the distance between the substrate and the discharge electrode, and the film thickness distribution.

[FIG. 12] A graph illustrating the relationship between the distance between the substrate and the discharge electrode, and the Raman ratio.

[FIG. 13] A graph illustrating the relationship between the n-layer deposition pressure and the conversion efficiency of a solar cell module.

[FIG. 14] A graph illustrating the relationship between the distance between the substrate and the discharge electrode, and the conversion efficiency of a solar cell module.
[FIG. 15] A graph illustrating the relationship between the thickness of the initial n-layer and the n-layer deposition time.
[FIG. 16] A graph illustrating the relationship between the thickness of the initial n-layer and the conversion efficiency of a solar cell module.

Explanation of Reference:

1: Substrate
2: Transparent electrode layer
3: Photovoltaic layer
4: Back electrode layer
5: Intermediate contact layer
6: Solar cell module
100: Photovoltaic device

Best Mode for Carrying Out the Invention

A description of a process for producing a photovoltaic device in accordance with a first embodiment of the present invention is presented below.
FIG. 1 is a schematic illustration of the structure of a photovoltaic device produced using the production process according to this embodiment. In FIG. 1, a photovoltaic device 100 is a silicon-based solar cell, and comprises a substrate 1, a transparent electrode layer 2, a photovoltaic layer 3, and a back electrode layer 4. The photovoltaic layer 3 comprises a p-layer and an i-layer each composed of a thin film of amorphous silicon, and an n-layer composed of a thin film of crystalline silicon stacked in that order from the sunlight incident side of the device. Here, the term "silicon-based" is a generic term that includes silicon (Si), silicon carbide (SiC) and silicon germanium (SiGe). Further, the term "crystalline silicon" describes silicon other than amorphous silicon, and includes both microcrystalline silicon and polycrystalline silicon.
A description of the steps for producing a solar cell panel using the process for producing a photovoltaic device according to the first embodiment is presented below, with reference to FIG. 2 through FIG. 5.

(1) FIG. 2(a)

A soda float glass substrate (in which the length of one side exceeds 1 m, for example, a substrate of 1.4 m × 1.1 m × thickness: 3 to 4 mm) is used as the substrate 1. The edges of the substrate are preferably subjected to corner chamfering or R-face chamfering to prevent damage caused by thermal stress or impacts or the like.

(2) FIG. 2(b)

A transparent electrode film comprising mainly tin oxide ($SnO_2$) and having a film thickness of approximately not less than 500 nm and not more than 800 nm is deposited as the transparent electrode layer 2 using a thermal CVD apparatus at a temperature of approximately 500°C. During this deposition, a texture comprising suitable unevenness is formed on the surface of the transparent electrode film. In addition to the transparent electrode film, the transparent electrode layer 2 may also include an alkali barrier film (not shown in the figure) formed between the substrate 1 and the transparent electrode film. The alkali barrier film is formed using a thermal CVD apparatus at a temperature of approximately 500°C to deposit a silicon oxide film ($SiO_2$) having a film thickness of not less than 50 nm and not more than 150 nm.

(3) FIG. 2(c)

Subsequently, the substrate 1 is mounted on an X-Y table, and the first harmonic of a YAG laser (1064 nm) is irradiated onto the surface of the transparent electrode layer, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

(4) FIG. 2(d)

Using an RF plasma CVD apparatus, a p-layer, an i-layer and an n-layer are stacked on the transparent electrode layer 2 in sequence from the sunlight incident side of the layer, thus forming the photovoltaic layer 3. First, $SiH_4$ gas, $H_2$ gas, $B_2H_6$ gas and $CH_4$ gas are introduced into the p-layer deposition chamber as raw material gases, and an amorphous B-doped Si film with a film thickness of not less than 8 nm and not more than 30 nm is deposited under conditions including a deposition pressure of not less than 30 Pa and not more than 1,000 Pa, a substrate temperature of approximately 200°C, and a frequency of 40 to 100 MHz.

Subsequently, $SiH_4$ gas and $H_2$ gas are introduced into the i-layer deposition chamber as raw material gases, and an amorphous Si film with a film thickness of not less than 200 nm and not more than 350 nm is deposited under conditions including a deposition pressure of not less than 30 Pa and not more than 1,000 Pa, a substrate temperature of approximately 220°C, and a frequency of 40 to 100 MHz.
A buffer layer may be provided between the p-layer film and the i-layer film in order to improve the interface properties.

Subsequently, an n-layer composed of crystalline silicon is deposited. By depositing the n-layer within an amorphous silicon-based solar cell as a crystalline silicon layer, the short-circuit current decreases, and the transmittance increases resulting in reduced light loss, meaning the cell performance can be improved.

An electrode such as that illustrated in FIG. 6 is used as the discharge electrode within the n-layer deposition chamber. In the electrode of FIG. 6, a plurality of discharge electrodes 60 extend (in a depth direction from the paper surface) in a substantially parallel relationship with the deposition surface of a substrate 61. In each discharge electrode 60, a slot is formed in the surface that faces the substrate 61, along the direction in which the discharge electrode extends. In other words, the shape of the discharge electrode 60 in a cross-section perpendicular to the direction of extension is an inverted U-shape that is open on the side that faces the substrate 61. A gas passage 62 through which the raw material gas flows is formed inside the base end section of the discharge electrode, and the raw material gas is able to be emitted substantially uniformly towards the substrate 61. In this embodiment, a distance d between the substrate and the discharge electrode is typically set to a value of not less than 6 mm and not more than 12 mm, and is preferably set to a value of not less than 8 mm and not more than 10 mm. This enables a high-density plasma to be maintained within the entire space between the substrate and the discharge electrode, resulting in an increased deposition rate. Further, by reducing in-plane variation in the distance d between the substrate and the discharge electrode, the film thickness distribution can be narrowed.

$SiH_4$ gas, $H_2$ gas and $PH_3$ gas are introduced into the n-layer deposition chamber as raw material gases, and the deposition pressure is adjusted to a value of not less than 500 Pa and not more than 1,000 Pa, and preferably not less than 500 Pa and not more than 800 Pa. An n-layer composed of crystalline silicon with a film thickness of not less than 20 nm and not more than 50 nm is then deposited under conditions including a substrate temperature of approximately 180°C, a frequency of 40 to 100 MHz, and a deposition rate of not less than 0.3 nm/sec.

By setting the distance d between the substrate and the discharge electrode to not less than 6 mm and not more than 12 mm, and performing the deposition at a deposition pressure of not less than 500 Pa and not more than 1,000 Pa, the density of the raw material gas is increased, and a uniform plasma can be generated. As a result, rapid deposition at a deposition rate of not less than 0.3 nm/sec can be achieved. The n-layer deposited under the conditions described above has a favorable film thickness distribution with the in-plane film thickness distribution being 20% or less. Furthermore, because collisions between the hydrogen radicals and raw material gases can be suppressed, an n-layer having a high degree of crystallinity with a Raman ratio of not less than 3.5 can be deposited.

(5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a point approximately 100 $\mu$m to 150 $\mu$m to the side of the laser etching line within the transparent electrode layer 2, so as to form a slot 11. The laser may also be irradiated from the side of the substrate 1. In this case, because the high vapor pressure generated by the energy absorbed by the photovoltaic layer 3 can be utilized, more stable laser etching processing can be performed. The position of the laser etching line is determined with due consideration of positioning tolerances, so as not to overlap with the previously formed etching line.

(6) FIG. 3(a)

Using a sputtering apparatus, an Ag film and a Ti film are deposited sequentially as the back electrode layer 4, under a reduced pressure atmosphere and at a temperature of approximately 150°C. In the present embodiment, the back electrode layer 4 is formed by sequentially stacking an Ag film having a thickness of not less than 200 nm and not more than 500 nm, and a highly corrosion-resistant Ti film having a thickness of not less than 10 nm and not more than 20 nm which acts as a protective film. In order to reduce the contact resistance between the n-layer of the photovoltaic layer 3 and the back electrode layer 4 and improve the reflectance, a GZO (Ga-doped ZnO) film with a film thickness of not less than 50 nm and not more than 100 nm may be deposited between the photovoltaic layer 3 and the back electrode layer 4 using a sputtering apparatus. Furthermore, an Al film of not less than 250 nm and not more than 350 nm may be used instead of the Ti film. By using Al instead of Ti, the material costs can be reduced while maintaining the anticorrosion effect.

(7) FIG. 3(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 μm to 400 μm to the side of the laser etching line within the transparent electrode layer 2, so as to form a slot 12.

(8) FIG. 3(c)

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). A Y-direction insulation slot need not be provided at this point, because a film surface polishing and removal treatment is conducted on the peripheral regions of the substrate 1 in a later step.

Completing the etching of the insulation slot 15 at a position 5 to 10 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YVO4 laser or fiber laser or the like may also be used in a similar manner.

(9) FIG. 4(a)

In order to ensure favorable adhesion and sealing of a backing sheet 24 via EVA or the like in a subsequent step, the stacked films around the periphery of the substrate 1 (in a peripheral region 14) are removed, as they tend to be uneven and prone to peeling. Grinding or blast polishing or the like is used to remove the back electrode layer 4, the photovoltaic layer 3, and the transparent electrode layer 2 from a region that is 5 mm to 20 mm from the edge around the entire periphery of the substrate 1, is closer to the substrate edge than the insulation slot 15 provided in the above step of FIG. 3(c) in the X direction, and is closer to the substrate edge than the slot 10 near the substrate edge in the Y direction. Grinding debris or abrasive grains are removed by washing the substrate 1.

(10) FIG. 4(b)

A terminal box attachment portion is prepared by providing an open through-window in the backing sheet 24 and exposing a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, in order to enable electric power to be extracted from a terminal box portion on the rear surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.

A backing sheet 24 with a superior waterproofing effect is positioned on top of the EVA. In this embodiment, in order to achieve a superior waterproofing and moisture-proofing effect, the backing sheet 24 is formed as a three-layer structure comprising a PET sheet, an Al foil, and a PET sheet.

The structure comprising the components up to and including the backing sheet 24 arranged in predetermined positions is subjected to internal degassing under a reduced pressure atmosphere and pressing at approximately 150°C to 160°C using a laminator, thereby causing cross-linking of the EVA that tightly seals the structure.

(11) FIG. 5(a)

A terminal box 23 is attached to the back of the solar cell module 6 using an adhesive.

(12) FIG. 5(b)

The copper foil and an output cable from the terminal box 23 are connected using solder or the like, and the interior of the terminal box is filled and sealed with a sealant (a potting material). This completes the production of the solar cell panel 50.

(13) FIG. 5(c)

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 $W/m^2$).

(14) FIG. 5(d)

In tandem with the electric power generation test (FIG. 5(c)), a variety of specific performance factors including the external appearance are evaluated.

The embodiment described above enables a silicon n-layer having a high degree of crystallinity to be deposited more rapidly than has conventionally been possible. As a result, a solar cell module having a high degree of efficiency can be produced with improved productivity due to the shortened takt time required for the n-layer deposition. Furthermore, the above embodiment enables the n-layer to be deposited with uniform film thickness, even in the case of large surface area substrates, meaning a photovoltaic device having superior electric power generation performance can be produced with excellent yield.

Next is a description of a process for producing a photovoltaic device according to a second embodiment of the present invention.

In this second embodiment, an initial n-layer is formed between the i-layer and the n-layer of the photovoltaic layer described in the first embodiment, thus forming a stacked structure composed of the initial n-layer and the n-layer. In this case, if due consideration is given to the deposition takt time, then the formation of the initial n-layer and the formation of the subsequent n-layer are preferably performed within the same deposition chamber.

Descriptions of the initial n-layer formation step and the n-layer formation step in the second embodiment are presented below.

An electrode such as that illustrated in FIG. 6 is used as the discharge electrode within the n-layer deposition chamber, and the distance d between the substrate and the discharge electrode is set to a value of not less than 6 mm and not more than 12 mm. $SiH_4$ gas, $H_2$ gas and $PH_3$ gas are introduced into the n-layer deposition chamber as raw material gases, and the deposition pressure is adjusted to a value of less than 500 Pa. An initial n-layer is then deposited under conditions including a substrate temperature of approximately 180°C and a frequency of 40 to 100 MHz. The thickness of the initial n-layer is preferably not less than 5 nm, and not more than 1/2 of the combined thickness of the n-layer and the initial n-layer.

Subsequently, the raw material gas flow rate is increased with the RF plasma state maintained, the deposition pressure is adjusted to a value of not less than 500 Pa and not more than 1,000 Pa, and preferably not less than 500 Pa and not more than 800 Pa, and an n-layer is deposited in the same manner as the first embodiment. In this case, because the initial n-layer and the n-layer are deposited in a continuous process, the takt time can be shortened. Alternatively, the plasma may be extinguished following deposition of the initial n-layer, and the plasma then regenerated to deposit the n-layer once the pressure has been altered and a stable state has been attained.

Increasing the deposition pressure and raising the n-layer deposition rate causes the doping element (P) within the n-layer to diffuse into the underlying i-layer, resulting in a deterioration in the interface properties between the n-layer and the i-layer. In contrast, if the deposition pressure is a low value of less than 500 Pa, then the Raman ratio of the deposited film is less than 3.5, indicating a low degree of crystallinity, and the deposition rate also slows, although diffusion of the doping element into the i-layer does not occur, meaning the interface properties can be improved. In the second embodiment, by forming the initial n-layer at a low deposition rate, with a thickness of not less than 5 nm and not more than 1/2 of the combined thickness of the n-layer and the initial n-layer, and subsequently forming the n-layer on top of the initial n-layer at a high deposition rate, the interface properties can be improved without dramatically increasing the time required for the deposition. As a result, a solar cell module having superior conversion efficiency is obtained, and the productivity can also be improved.

In the embodiments described above, single layer amorphous silicon solar cells were described as examples, but the present invention is not limited to such structures. The process for producing a photovoltaic device according to the present invention can also be applied to microcrystalline silicon solar cells, tandem solar cells and triple solar cells and the like.

Furthermore, the above embodiments described solar cells in which the p-layer, the i-layer and the n-layer were formed in sequence on the substrate, with the incident light entering from the side of the p-layer, but the n-layer, the i-layer and the p-layer may be formed in sequence on a conductive substrate, or the incident light may enter from the side of the n-layer. The productivity can be improved by enabling rapid deposition of the n-layer, and by increasing the Raman ratio of the n-layer, the light absorption loss within the n-layer can be reduced, yielding an improvement in the electric power generation performance. Further, by forming the initial n-layer, the interface properties can be improved, meaning any reduction in the electric power generation performance can be suppressed.

Moreover, the present invention can also be applied to solar cells in which plasma CVD is used to form a crystalline silicon n-layer on a crystalline semiconductor substrate.

Examples of the present invention are described below.

[Example 1]

Using the discharge electrode illustrated in FIG. 6 as the discharge electrode for an RF plasma CVD apparatus, the distance d between the substrate and the discharge electrode was set to 5 mm, 6 mm, 8 mm, 10 mm, and 12 mm respectively.

The raw material gases were supplied to the n-layer deposition chamber in a gas flow ratio of $SiH_4$:$H_2$:$PH_3$ = 1:100:0.005, so as to obtain a deposition pressure within a range from 200 Pa to 1,200 Pa. With the substrate temperature set to 180°C, a high frequency wave of 60 MHz and 5 kW was applied to generate a plasma, and deposition of an n-type silicon film was conducted for a deposition time of sufficient length to produce a film thickness of 120 nm on the surface of the soda float glass substrate (1.4 m × 1.1 m × thickness: 4 mm).

Following deposition, a spectroscopic ellipsometry method was used to measure the film thickness at 189 points within the substrate plane, and the average film thickness and the film thickness distribution were calculated. Here, the film thickness distribution was determined using the formula:

$$\{(\text{maximum thickness})-(\text{minimum thickness})\}/\{2\times(\text{average thickness})\}.$$

Following film deposition, the substrate was partitioned, and the Raman ratio was measured at 25 points within the substrate plane. The second harmonic of a YAG laser (532 nm) was used as the measuring light. The measuring light was irradiated onto the film surface, the Raman scattered light was detected, and the ratio between the crystalline silicon peak intensity at 520 $cm^{-1}$ and the amorphous silicon peak intensity at 480 $cm^{-1}$ was calculated from the resulting Raman scattering spectrum.

FIG. 7 illustrates the relationship between the deposition pressure and the deposition rate for the n-layer. In this figure, the horizontal axis represents the deposition pressure and the vertical axis represents the deposition rate. A trend was observed wherein the deposition rate increased as the deposition pressure was increased. At each of the different substrate-electrode distances d, the deposition rate was 0.3 nm/sec or greater for deposition pressures of not less than 500 Pa and not more than 1,000 Pa.

FIG. 8 illustrates the relationship between the deposition pressure and the film thickness distribution. In this figure, the horizontal axis represents the deposition pressure and the vertical axis represents the film thickness distribution. At each of the different substrate-electrode distances d, the film thickness distribution was 20% or less for deposition pressures of not more than 1,000 Pa. When the pressure exceeded 1,000 Pa, the film thickness distribution exceeded 20%, and a trend towards increased variation in the film thickness within the substrate plane was observed.

FIG. 9 illustrates the relationship between the deposition pressure and the Raman ratio. In this figure, the horizontal axis represents the deposition pressure and the vertical axis represents the Raman ratio. When the deposition pressure was low, the Raman ratio was not less than 3.5, and a silicon film with a high degree of crystallinity was obtained. At a deposition pressure of 1,200 Pa, the Raman ratio fell below 3.5, and the crystallinity deteriorated.

[Example 2]

Using the discharge electrode illustrated in FIG. 6 as the discharge electrode for an RF plasma CVD apparatus, n-layers were deposited with the distance d between the substrate and the discharge electrode altered between 5 mm and 15 mm. In example 2, the deposition pressure was set to either 700 Pa or 1,000 Pa, while the remaining deposition conditions and measurement conditions were the same as those described for example 1.

FIG. 10 is a graph in which the horizontal axis represents the substrate-electrode distance and the vertical axis represents the deposition rate. FIG. 11 is a graph in which the horizontal axis represents the substrate-electrode distance and the vertical axis represents the film thickness distribution. FIG. 12 is a graph in which the horizontal axis represents the substrate-electrode distance and the vertical axis represents the Raman ratio.

When the substrate-electrode distance was not less than 6 mm and not more than 12 mm, a silicon film with a high degree of crystallinity and a Raman ratio of not less than 3.5 was able to be deposited at a rapid rate (of at least 0.3 nm/sec). When the substrate-electrode distance was 5 mm, the film thickness distribution was extremely poor, but when the substrate-electrode distance was not less than 6 mm and not more than 12 mm, a favorable film thickness distribution was achieved.

From the results of example 1 and example 2 it was evident that by depositing the n-layer at a deposition pressure of not less than 500 Pa and not more than 1,000 Pa, and a substrate-electrode distance of not less than 6 mm and not more than 12 mm, the deposition rate for the n-layer could be increased, and an n-layer having a high degree of crystallinity and a favorable film thickness distribution could be obtained.

[Example 3]

Solar cell modules were prepared using the steps described for the first embodiment. The deposition conditions for the p-layer, the i-layer and the n-layer of the photovoltaic layer, and the back electrode layer were as described below.

Raw material gases were supplied to the p-layer deposition chamber in a gas flow ratio of $SiH_4$:$H_2$:$B_2H_6$ (hydrogen base concentration 0.5%):$CH_4$ = 0.2:4.8:0.8:1.0, and the deposition pressure was set to 140 Pa. The substrate temperature was set to 200°C. A high frequency wave of 60 MHz and 5 kW was applied to generate a plasma, and a p-type amorphous silicon film with a film thickness of 8 nm was deposited as the p-layer. A buffer layer with a thickness of 5 nm was then deposited.

Raw material gases were then supplied to the i-layer deposition chamber in a gas flow ratio of $SiH_4$:$H_2$ = 1:3, and the deposition pressure was set to 200 Pa. The substrate temperature was set to 220°C, a high frequency wave of 60 MHz and 5 kW was applied to generate a plasma, and an i-type amorphous silicon film with a film thickness of 250 nm was deposited as the i-layer.

For the n-layer, the substrate-electrode distance in the RF plasma CVD apparatus was set to 8 mm, and an n-type silicon film with a film thickness of 30 nm was deposited under the same conditions as those described for example 1.

Subsequently, a GZO film with a film thickness of 60 nm, an Ag film with a film thickness of 250 nm and a Ti film with a film thickness of 15 nm as the back electrode layer were stacked sequentially on top of the n-layer.

FIG. 13 is a graph in which the horizontal axis represents the deposition pressure and the vertical axis represents the conversion efficiency of the solar cell module. For a deposition pressure within a range from 400 Pa to 500 Pa, a high conversion efficiency of 9.7 to 9.8% was obtained. However, as illustrated in FIG. 7, when the deposition pressure was set to a value less than 500 Pa, the deposition rate for the n-layer was slow, the takt time increased, and increasing the productivity of the solar cell module was impossible. The conversion efficiency tended to decrease as the deposition pressure was increased, but the conversion efficiency was still 8.5% or greater for deposition pressures of 1,000 Pa or less.

Comparison of FIG. 9 and FIG. 13 reveals a good correlation between the conversion efficiency of the solar cell module and the Raman ratio of the n-layer. Accordingly, even if the substrate-electrode distance is altered to 6 mm, 10 mm or 12 mm, a high conversion efficiency can still be obtained at a deposition pressure of 1,000 Pa, which yields a high Raman ratio.

[Example 4]

Solar cell modules were prepared using the steps described for the first embodiment. The deposition conditions for the p-layer and the i-layer of the photovoltaic layer, and the back electrode layer were the same as those described for example 3. In the case of the n-layer, the deposition pressure was set to 700 Pa, and with the remaining deposition conditions set to the same values as those described for example 2, an n-type silicon film with a film thickness of 30 nm was deposited.

FIG. 14 is a graph in which the horizontal axis represents the substrate-electrode distance and the vertical axis represents the conversion efficiency of the solar cell module. A conversion efficiency of 8.5% or greater was obtained for substrate-electrode distances of not less than 6 mm and not more than 12 mm.

Comparison of FIG. 12 and FIG. 14 reveals a good correlation between the conversion efficiency of the solar cell module and the Raman ratio of the n-layer. For example, even at a deposition pressure of 1,000 Pa, a high conversion efficiency was obtained when the substrate-electrode distance was not less than 6 mm and not more than 12 mm.

The conversion efficiency of a solar cell module when an n-type amorphous silicon is formed as the n-layer is approximately 8%. Accordingly, by forming a silicon n-layer with a high degree of crystallinity, such as the n-layers described in example 3 and example 4, under conditions including a substrate-electrode distance of not less than 6 mm and not more than 12 mm, and a deposition pressure of not less than 500 Pa and not more than 1,000 Pa, the conversion efficiency of the solar cell module was able to be improved. Furthermore, under the above conditions, a silicon n-layer with a high degree of crystallinity was able to be deposited at a rapid rate, meaning the productivity of the solar cell module was able to be improved.

[Example 5]

Solar cell modules were prepared using the steps described for the first embodiment. The deposition conditions for the p-layer and the i-layer of the photovoltaic layer, and the back electrode layer were the same as those described for example 3. The deposition conditions for the initial n-layer and the n-layer were as described below.

The distance between the substrate and the electrode within the RF plasma CVD apparatus was set to 8 mm. Raw material gases were supplied to the n-layer deposition chamber in a gas flow ratio of $SiH_4:H_2:PH_3$ = 1:100:0.005 so as to achieve a deposition pressure of 400 Pa. The substrate temperature was set to 180°C, and a high frequency wave of 60 MHz and 5 kW was applied to generate a plasma, thereby depositing an initial n-layer. The deposition rate of the initial n-layer under the above conditions was 0.25 nm/sec.

Subsequently, with the RF plasma maintained, the deposition pressure was altered from 400 Pa to 700 Pa, and an n-layer was deposited in such a manner that the combined thickness of the initial n-layer and the n-layer was 30 nm. The deposition rate of the n-layer under the above conditions was 0.4 nm/sec. The time required for altering the deposition pressure conditions was approximately 5 seconds.

FIG. 15 is a graph in which the horizontal axis represents the thickness of the initial n-layer and the vertical axis represents the deposition time required to deposit a stacked structure of the initial n-layer and the n-layer with a combined thickness of 30 nm. FIG. 16 is a graph in which the horizontal axis represents the initial n-layer thickness and the vertical axis represents the conversion efficiency of the solar cell module. In FIG. 15 and FIG. 16, a thickness of 0 nm represents the case in which only an n-layer was deposited, whereas a thickness of 30 nm represents the case in which only an initial n-layer was deposited.

By forming an initial n-layer with a thickness of not less than 5 nm and then forming the n-layer, a high-efficiency solar cell module with a conversion efficiency of approximately 9.7% was obtained. However, as the thickness of the initial n-layer is increased, the deposition time lengthens. If the productivity of the solar cell module is also considered, then the total deposition time for the initial n-layer and the n-layer is preferably not more than 100 seconds. A deposition time of not more than 100 seconds can be achieved provided the thickness of the initial n-layer in FIG. 15 is not more than 15 nm, that is, provided the thickness of the initial n-layer is not more than 1/2 of the total n-layer thickness.

## Claims

1. A process for producing a photovoltaic device comprising an n-layer formation step of depositing an n-layer composed of crystalline silicon on a substrate disposed inside a deposition chamber under reduced pressure conditions by heating the substrate with a heating device to convert the substrate to a heated state, supplying a raw material gas to the inside of the deposition chamber, and then supplying power to a discharge electrode positioned opposing the substrate, wherein
the n-layer formation step comprises depositing the n-layer with a pressure inside the deposition chamber set to not less than 500 Pa and not more than 1,000 Pa, and a distance between the substrate and the discharge electrode set to not less than 6 mm and not more than 12 mm.

2. The process for producing a photovoltaic device according to claim 1, wherein a deposition rate for the n-layer is not less than 0.3 nm/sec.

3. The process for producing a photovoltaic device according to claim 1 or claim 2, wherein the n-layer is deposited such that a Raman ratio for the n-layer is not less than 3.5.

4. The process for producing a photovoltaic device according to any one of claim 1 to claim 3, wherein the n-layer is deposited such that a film thickness distribution for the n-layer is not more than 20%.

5. The process for producing a photovoltaic device according to any one of claim 1 to claim 4,
further comprising an initial n-layer formation step immediately prior to the n-layer formation step, wherein
the initial n-layer formation step comprises depositing the initial n-layer with a pressure inside the deposition chamber set to less than 500 Pa, and a distance between the substrate and the discharge electrode set to not less than 6 mm and not more than 12 mm.

6. The process for producing a photovoltaic device according to claim 5, wherein deposition is conducted so that a thickness of the initial n-layer is not less than 5 nm, and not more than 1/2 of a combined thickness of the n-layer and the initial n-layer.

7. A thin-film photovoltaic device comprising at least, a transparent conductive film, at least one photovoltaic layer and a back electrode layer disposed on top of a substrate, wherein the photovoltaic layer has at least an n-layer, and the n-layer is a crystalline silicon layer having a Raman ratio of not less than 3.5 and a film thickness distribution of not more than 20%.

8. A thin-film photovoltaic device comprising at least, a transparent conductive film, at least one photovoltaic layer and a back electrode layer disposed on top of a substrate, wherein the photovoltaic layer has at least a stacked structure composed of an initial n-layer and an n-layer, the n-layer is a crystalline silicon layer having a Raman ratio of not less than 3.5 and a film thickness distribution of not more than 20%, and the initial n-layer is a silicon layer having a Raman ratio of less than 3.5.

FIG. 1

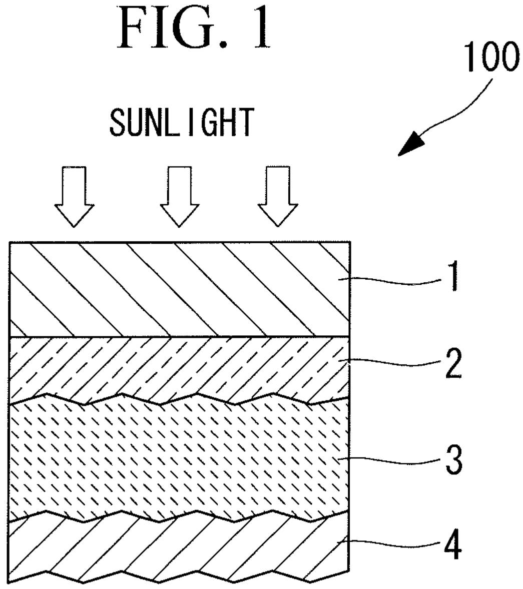

FIG. 2

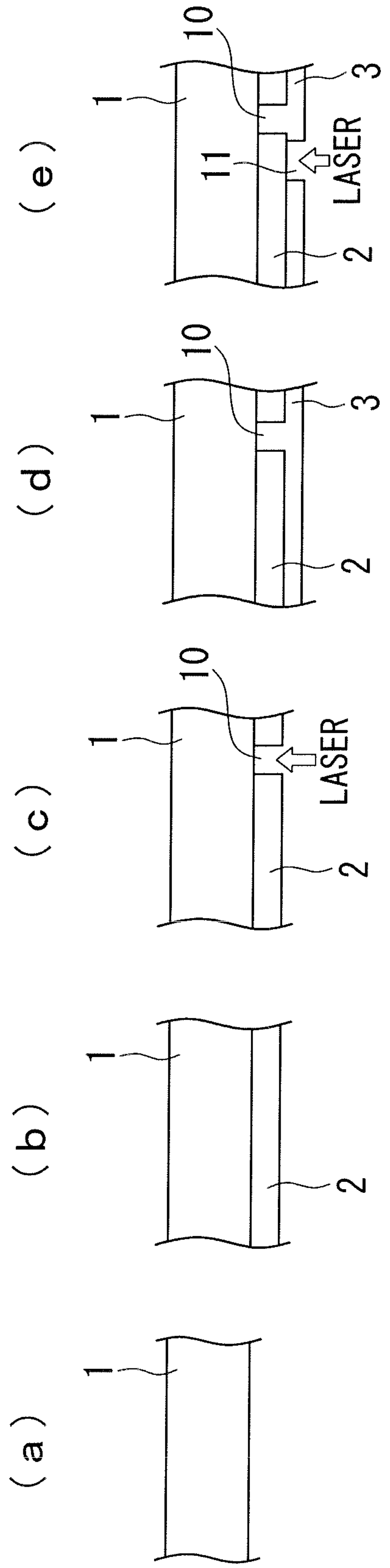

FIG. 3

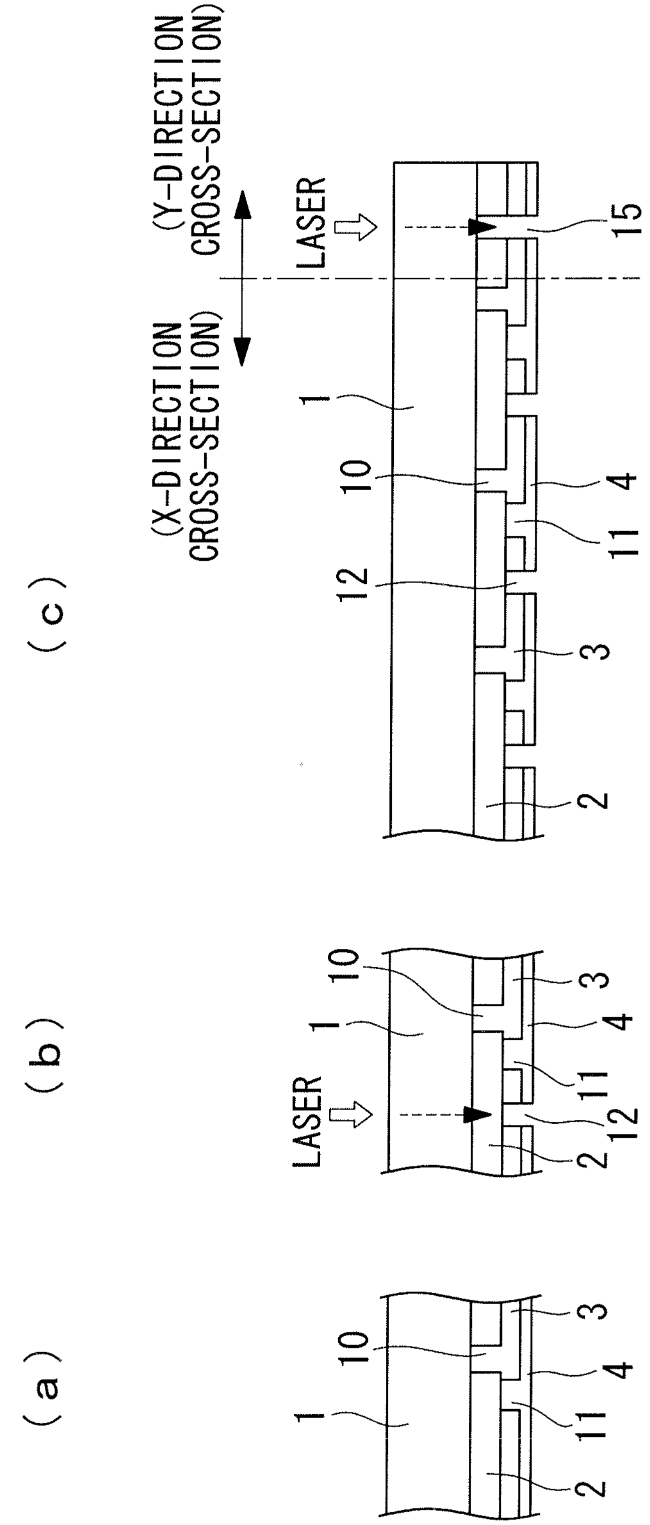
(a)
(b)
(c)
LASER
(X-DIRECTION CROSS-SECTION)
(Y-DIRECTION CROSS-SECTION)
1
2
3
4
10
11
12
15

FIG. 4

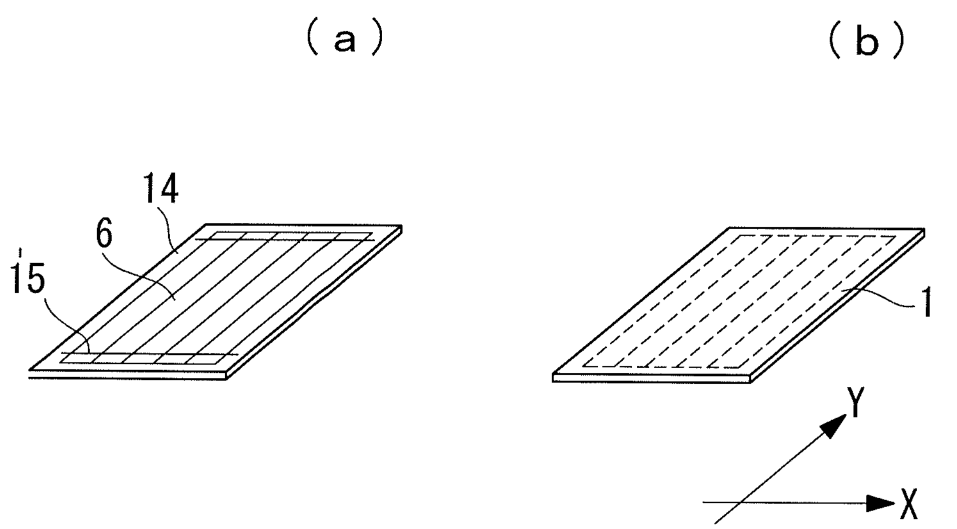

FIG. 5

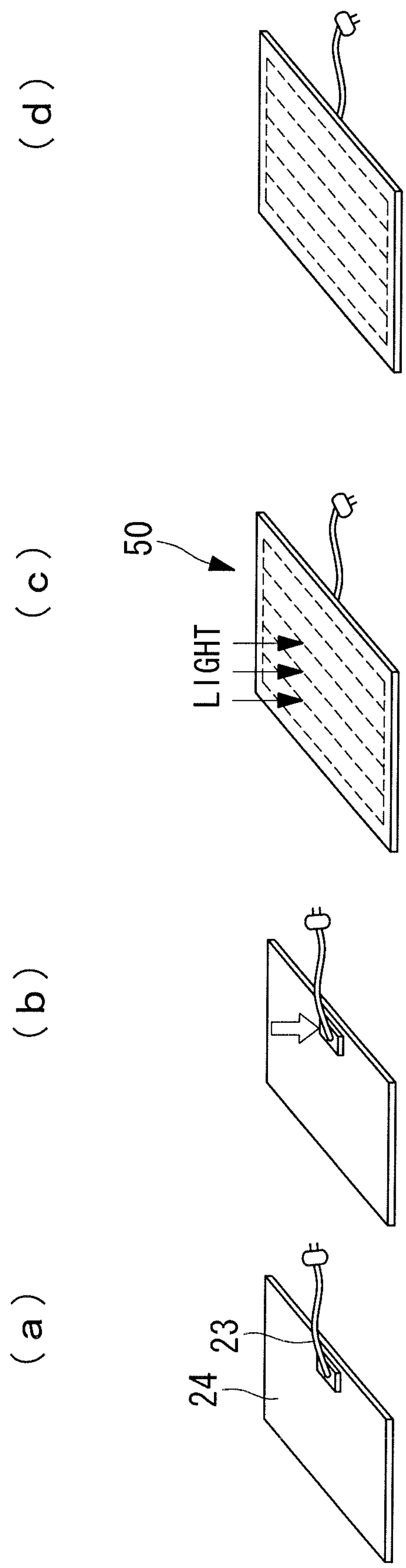

FIG. 6

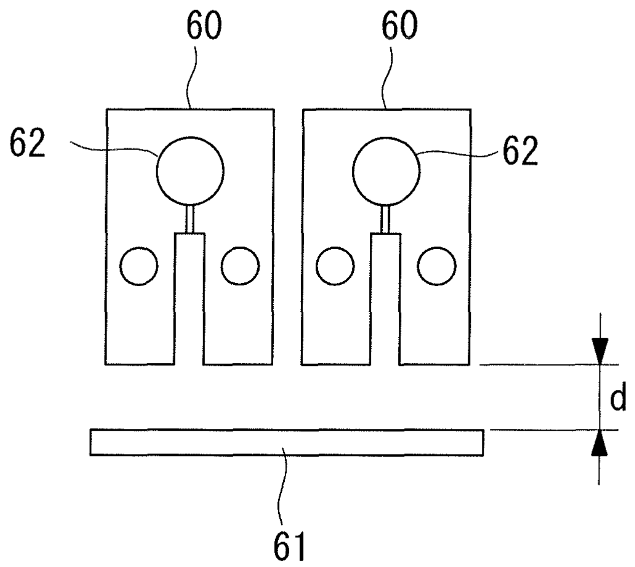
60
60
62
62
d
61

FIG. 7

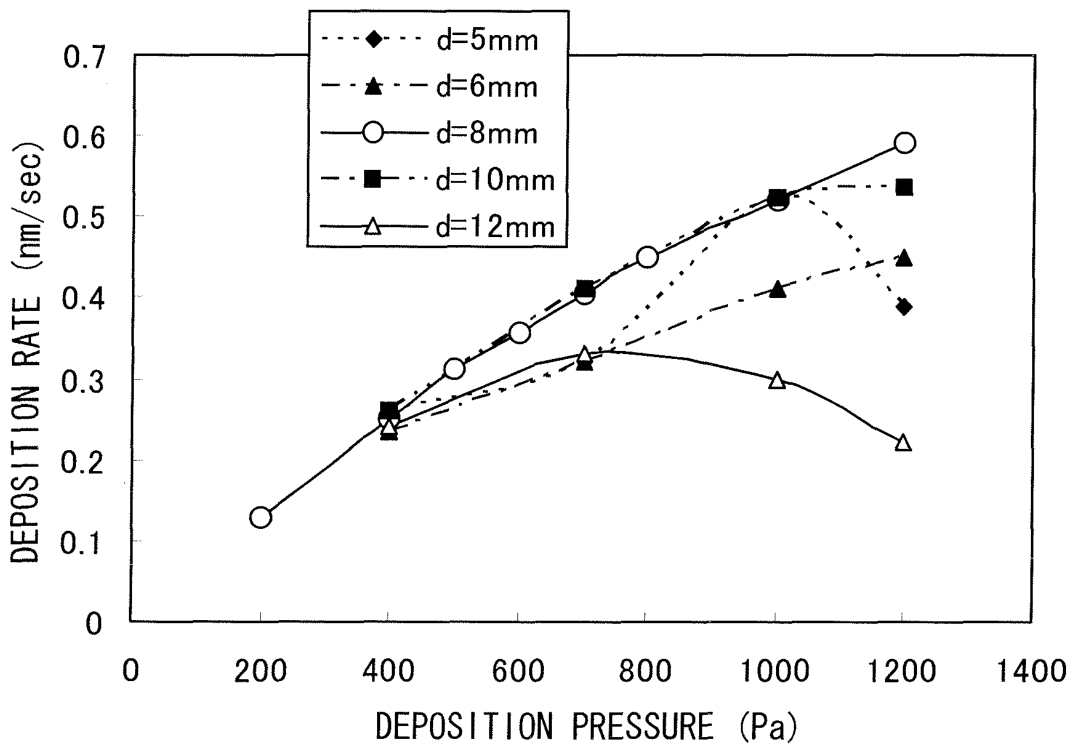
d=5mm
d=6mm
d=8mm
d=10mm
d=12mm
0.7
0.6
0.5
0.4
0.3
0.2
0.1
0
DEPOSITION RATE (nm/sec)
0
200
400
600
800
1000
1200
1400
DEPOSITION PRESSURE (Pa)

FIG. 8

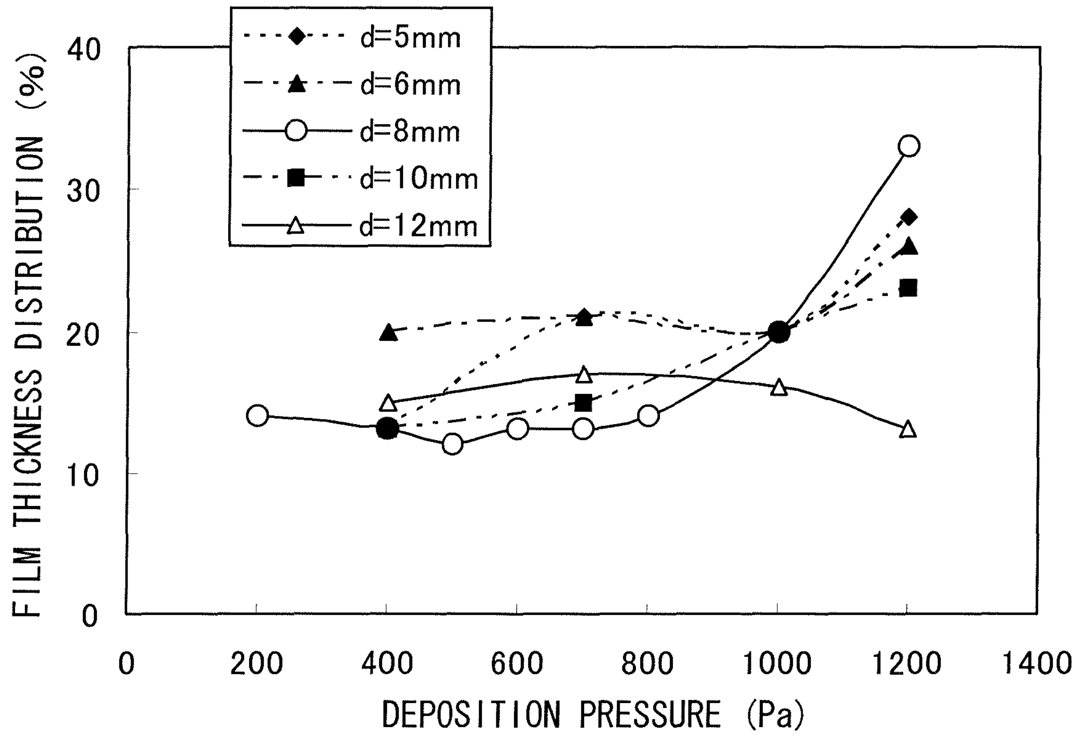
d=5mm
d=6mm
d=8mm
d=10mm
d=12mm
FILM THICKNESS DISTRIBUTION (%)
40
30
20
10
0
0
200
400
600
800
1000
1200
1400
DEPOSITION PRESSURE (Pa)

FIG. 9

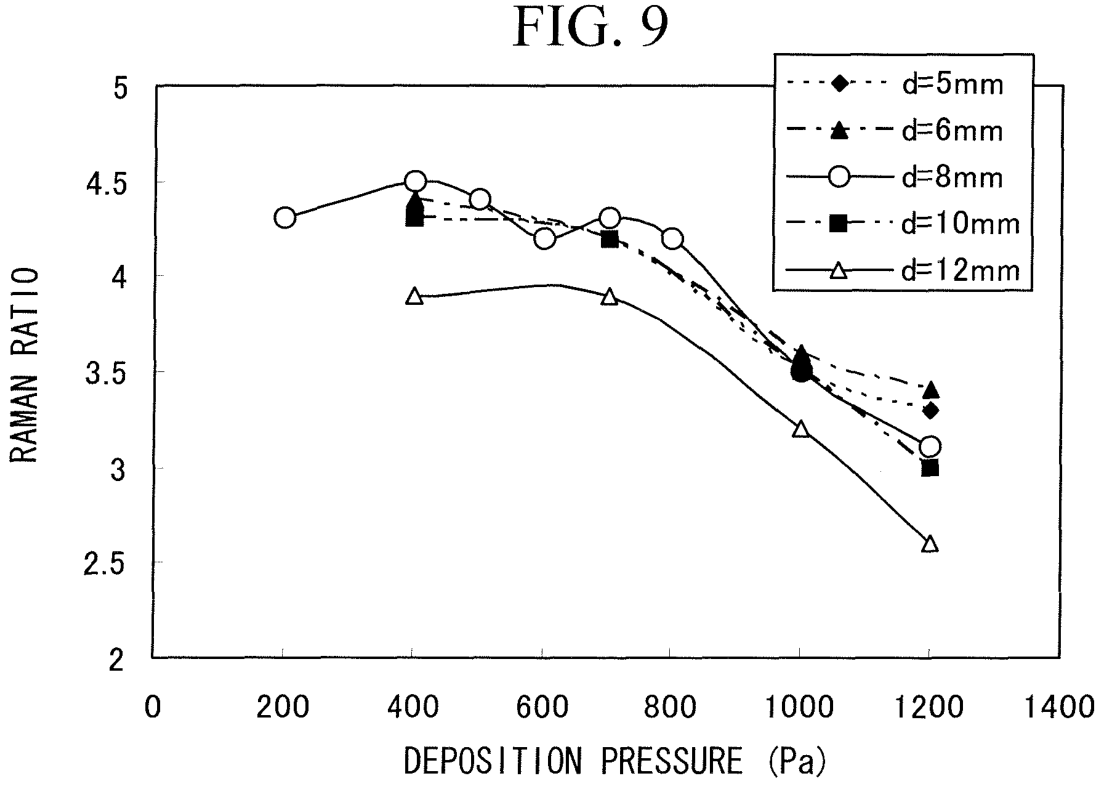
d=5mm
d=6mm
d=8mm
d=10mm
d=12mm
RAMAN RATIO
5
4.5
4
3.5
3
2.5
2
0
200
400
600
800
1000
1200
1400
DEPOSITION PRESSURE (Pa)

FIG. 10

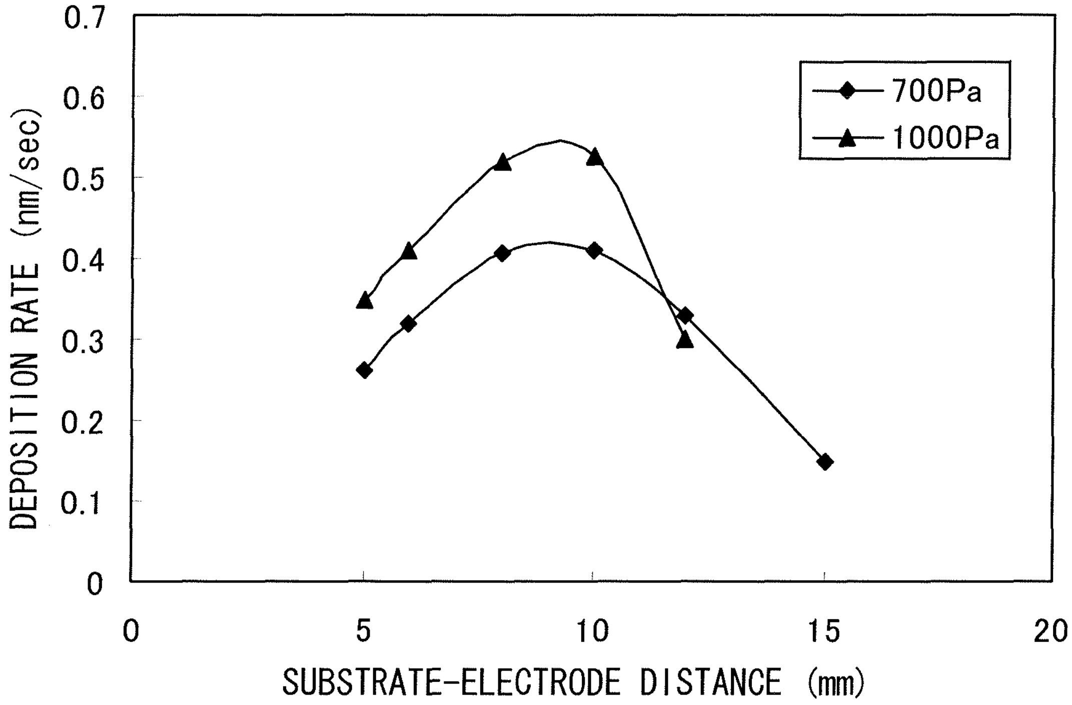
0.7
0.6
0.5
0.4
0.3
0.2
0.1
0
DEPOSITION RATE (nm/sec)
700Pa
1000Pa
0
5
10
15
20
SUBSTRATE-ELECTRODE DISTANCE (mm)

FIG. 11

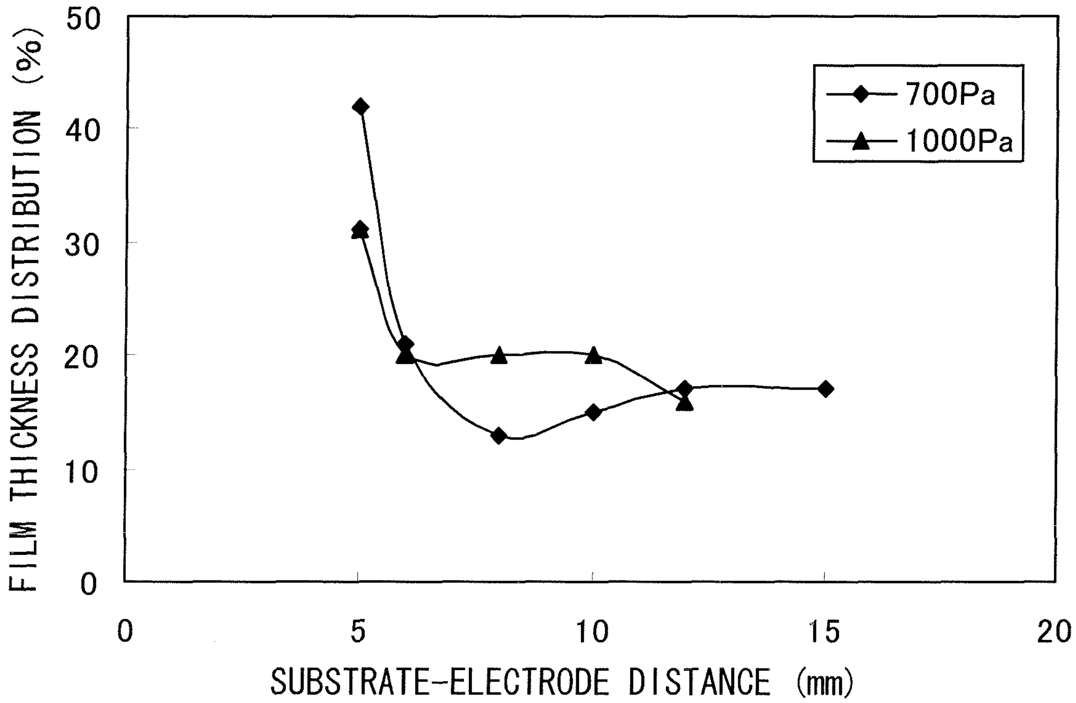
50
40
30
20
10
0
FILM THICKNESS DISTRIBUTION (%)
700Pa
1000Pa
0
5
10
15
20
SUBSTRATE-ELECTRODE DISTANCE (mm)

FIG. 12

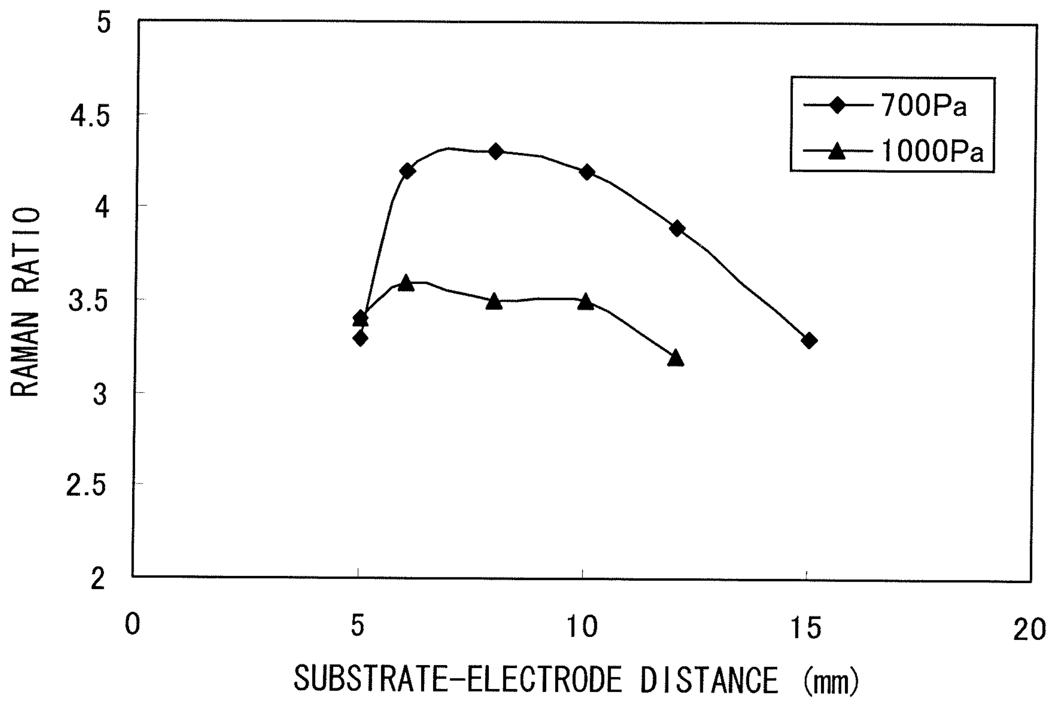
5
4.5
4
3.5
3
2.5
2
RAMAN RATIO
700Pa
1000Pa
0
5
10
15
20
SUBSTRATE-ELECTRODE DISTANCE (mm)

FIG. 13

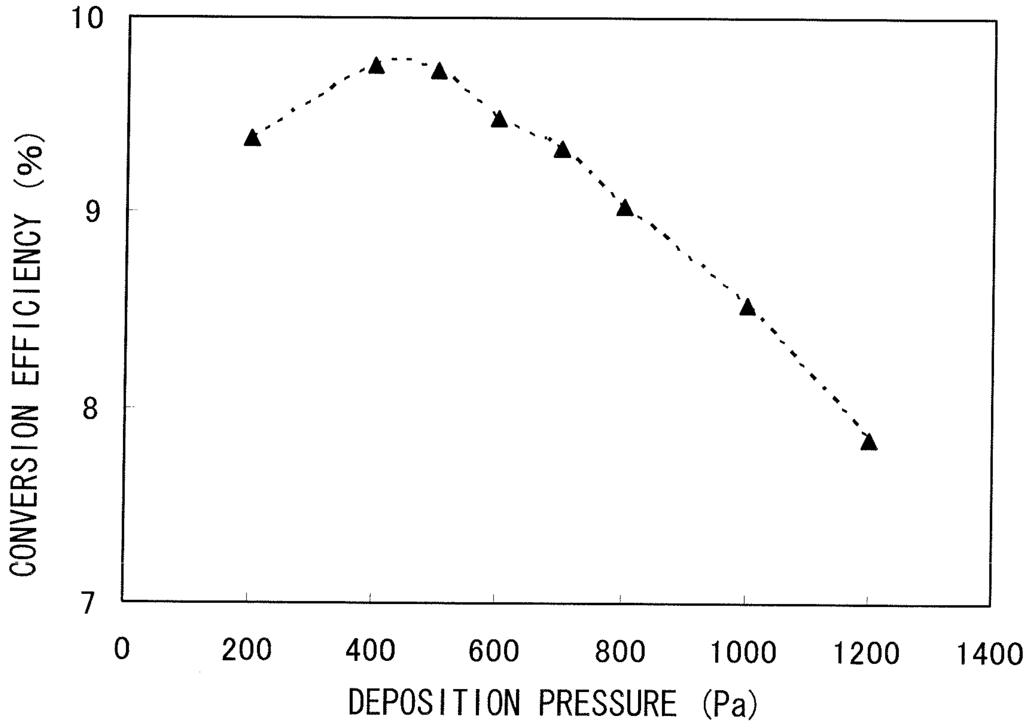
10
9
8
7
CONVERSION EFFICIENCY (%)
0
200
400
600
800
1000
1200
1400
DEPOSITION PRESSURE (Pa)

FIG. 14

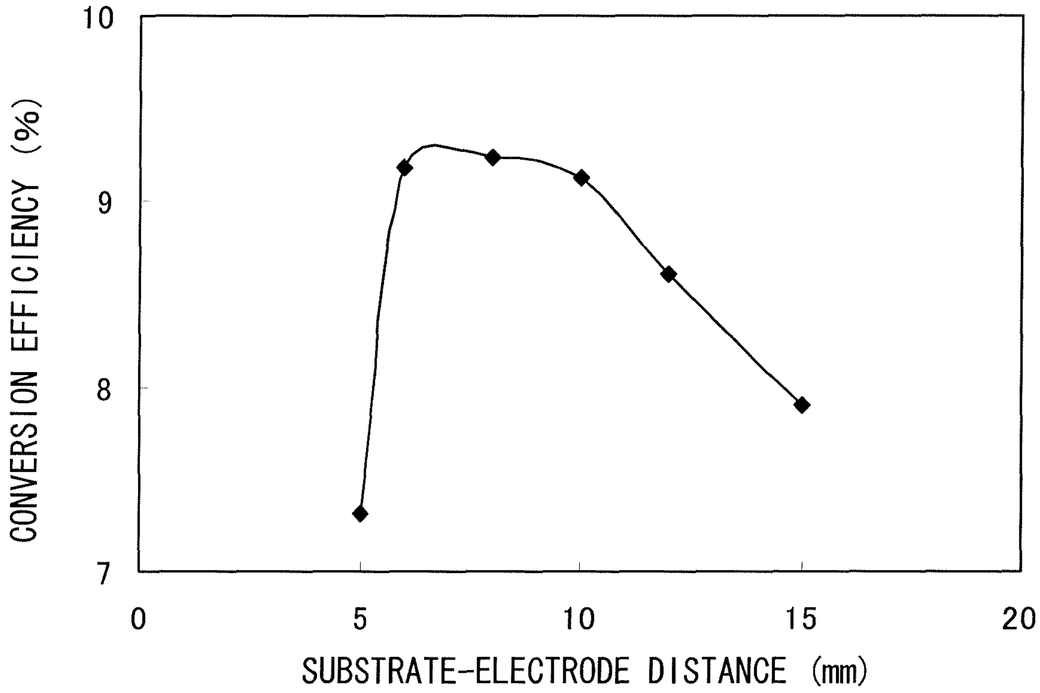
10
9
8
7
CONVERSION EFFICIENCY (%)
0
5
10
15
20
SUBSTRATE-ELECTRODE DISTANCE (mm)

FIG. 15

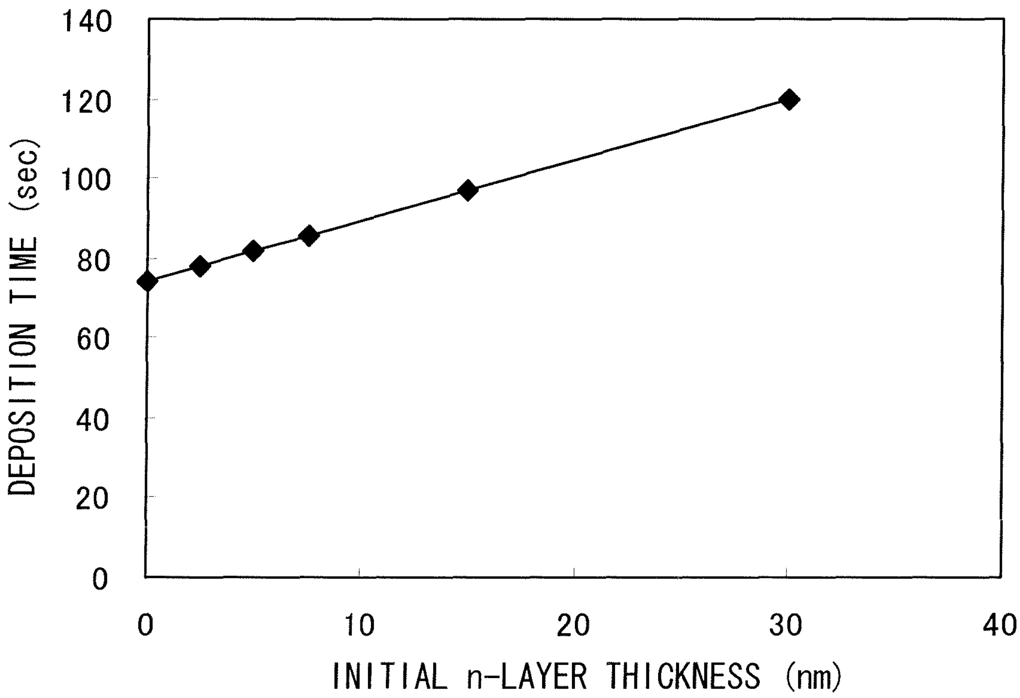
140
120
100
80
60
40
20
0
DEPOSITION TIME (sec)
0
10
20
30
40
INITIAL n-LAYER THICKNESS (nm)

FIG. 16

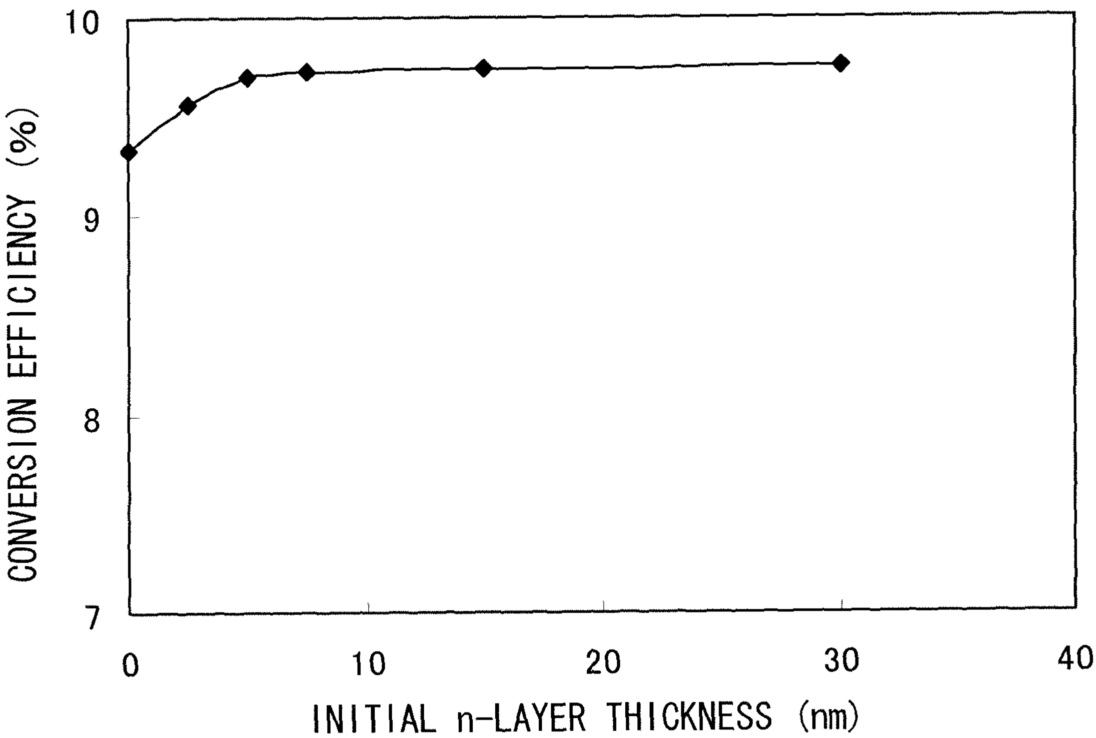
10
9
8
7
CONVERSION EFFICIENCY (%)
0
10
20
30
40
INITIAL n-LAYER THICKNESS (nm)

**INTERNATIONAL SEARCH REPORT**

International application No.
PCT/JP2008/073176

A. CLASSIFICATION OF SUBJECT MATTER
*H01L31/20*(2006.01)i, *H01L31/075*(2006.01)i

According to International Patent Classification (IPC) or to both national classification and IPC

B. FIELDS SEARCHED

Minimum documentation searched (classification system followed by classification symbols)
H01L31/00-31/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2007-305826 A (Kaneka Corp.), 22 November, 2007 (22.11.07), (Family: none) | 1-8 |
| X<br>Y | JP 2007-150151 A (Mitsubishi Heavy Industries, Ltd.), 14 June, 2007 (14.06.07), (Family: none) | 1-4,7<br>5-6,8 |
| Y | JP 2004-266111 A (Fuji Electric Holdings Co., Ltd.), 24 September, 2004 (24.09.04), (Family: none) | 1-8 |
| Y | JP 2003-68659 A (Sharp Corp.), 07 March, 2003 (07.03.03), (Family: none) | 1-8 |

☐ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 March, 2009 (16.03.09) | 31 March, 2009 (31.03.09) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2008/073176

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

In claims 1-6, an n-layer forming step is specified by a pressure in a film-forming chamber and a distance between a substrate and a discharge electrode, whereas in claim 7, an n-layer is specified by a Raman ratio, and in claim 8, an n-layer and an initial n-layer are specified by Raman ratios, respectively. (Continued to extra sheet.)

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.
PCT/JP2008/073176

Continuation of Box No.III of continuation of first sheet(2)

There is no specific relationship among claims 1-6, claim 7 and claim 8, since such phenomenon that the Raman ratio (crystallization ratio) of the n-layer changes under various conditions, such as film-forming temperature and film-forming speed, in addition to the above-mentioned pressure and distance, is well known.

Therefore, the above-mentioned three features are different inventions.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006216921 A